(19) 

Europäisches
Patentamt
European
Patent Office
Office européen
des brevets

(11) **EP 3 624 335 A1**

(12) **EUROPEAN PATENT APPLICATION**
published in accordance with Art. 153(4) EPC

(43) Date of publication:
**18.03.2020 Bulletin 2020/12**

(51) Int Cl.:
**H03F 1/07** (2006.01)

(21) Application number: **17914477.9**

(86) International application number:
**PCT/JP2017/023200**

(22) Date of filing: **23.06.2017**

(87) International publication number:
**WO 2018/235261 (27.12.2018 Gazette 2018/52)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Mitsubishi Electric Corporation**
**Chiyoda-ku**
**Tokyo 100-8310 (JP)**

(72) Inventors:
• **SAKATA, Shuichi**
  **Tokyo 100-8310 (JP)**
• **KOMATSUZAKI, Yuji**
  **Tokyo 100-8310 (JP)**
• **SHINJO, Shintaro**
  **Tokyo 100-8310 (JP)**

(74) Representative: **Pfenning, Meinig & Partner mbB**
**Patent- und Rechtsanwälte**
**Theresienhöhe 11a**
**80339 München (DE)**

(54) **HIGH-FREQUENCY AMPLIFIER**

(57)    An apparatus includes an envelope detecting unit (9) for detecting an envelope of a signal to be amplified, and a variable power supply (10) applies, to an output terminal of a carrier amplifier (5), a voltage increased with increase in the envelope detected by the envelope detecting unit (9). As a result, highly efficient operation can be implemented without including a phase shifter including a quarter wavelength line or the like.

FIG. 1

**Description**

TECHNICAL FIELD

The present invention relates to a high-frequency amplifier including a carrier amplifier and a peak amplifier.

BACKGROUND ART

Patent Literature 1 below discloses a Doherty type high-frequency amplifier including a carrier amplifier and a peak amplifier.

The high-frequency amplifier distributes an input high frequency signal to the carrier amplifier and the peak amplifier.

The carrier amplifier amplifies one of the distributed high frequency signals, and if the power of the other of the distributed high frequency signals is greater than or equal to a predetermined power, the peak amplifier amplifies the other of the distributed high frequency signals.

The high-frequency amplifier combines the high frequency signal amplified by the carrier amplifier and the high frequency signal amplified by the peak amplifier, and outputs the combined high frequency signal.

This high-frequency amplifier includes, on the input side of the peak amplifier, a phase shifter for adjusting the phase of the other of the distributed high frequency signals and, on the output side of the carrier amplifier, a phase shifter for adjusting the phase of the amplified high frequency signal.

The phase shifter on the input side of the peak amplifier is provided in order to implement highly efficient operation even when the power of an input high frequency signal changes.

The phase shifter on the output side of the carrier amplifier is provided in order to combine the high frequency signal amplified by the carrier amplifier and the high frequency signal amplified by the peak amplifier.

The carrier amplifier is a source-grounded transistor, and the high-frequency amplifier includes a power source modulating unit for applying a voltage to a drain terminal, which is an output terminal of the carrier amplifier.

The power supply modulating unit applies the calculated drain voltage to the drain terminal of the carrier amplifier if a drain voltage calculated from an envelope of the input high frequency signal is higher than or equal to a threshold voltage, and if the calculated drain voltage is less than the threshold voltage, applies the threshold voltage to the drain terminal of the carrier amplifier.

The power supply modulating unit is provided for the purpose of improving the efficiency when the power of the input high frequency signal is low.

CITATION LIST

PATENT LITERATURE

Patent Literature 1: WO 2010/084544 A

SUMMARY OF INVENTION

TECHNICAL PROBLEM

A high-frequency amplifier of the related art include a phase shifter which includes a quarter wavelength line or the like.

By providing a phase shifter including a quarter wavelength line or the like, highly efficient operation can be implemented. However, there is a disadvantage that frequency bands that enable implementation of highly efficient operation are limited since the frequency of a high frequency signal that enables implementation of highly efficient operation is limited to those close of the center frequency of the quarter wavelength line.

The present invention has been devised to solve the above-described disadvantage, and an object of the present invention is to obtain a high-frequency amplifier that enables implementation of highly efficient operation without including a phase shifter including a quarter wavelength line or the like.

SOLUTION TO PROBLEM

A high-frequency amplifier according to the present invention includes: a signal distributor for distributing a signal to be amplified; a carrier amplifier for amplifying one signal distributed by the signal distributor; a peak amplifier for amplifying the other signal distributed by the signal distributor; a signal synthesizer for combining the signal amplified by the carrier amplifier and the signal amplified by the peak amplifier; and an envelope detecting unit for detecting an envelope of the signal to be amplified, wherein a variable power supply applies, to an output terminal of the carrier amplifier, a voltage increased with increase in the envelope detected by the envelope detecting unit.

ADVANTAGEOUS EFFECTS OF INVENTION

According to the present invention, an envelope detecting unit for detecting an envelope of a signal to be amplified is provided, and a variable power supply applies, to an output terminal of a carrier amplifier, a voltage increased with increase in the envelope detected by the envelope detecting unit, therefore an effect is exerted that highly efficient operation can be implemented without including a phase shifter including a quarter wavelength line or the like.

BRIEF DESCRIPTION OF DRAWINGS

FIG. 1 is a configuration diagram illustrating a high-frequency amplifier according to a first embodiment of the present invention.
FIG. 2 is an explanatory graph indicating the relationship between an amplitude B indicating the size of an envelope normalized by the maximum value $B_{MAX}$ of the amplitude and a drain voltage V normalized by the maximum value $V_{MAX}$ of the drain voltage.
FIG. 3 is an explanatory graph indicating a simulation result of the relationship between the output power and the efficiency of the high-frequency amplifier.
FIG. 4 is an explanatory graph indicating a simulation result of the frequency dependency of the efficiency at a back-off of 6 dB.
FIG. 5 is a configuration diagram illustrating a high-frequency amplifier according to a second embodiment of the invention.
FIG. 6 is an explanatory graph indicating the relationship between an amplitude B indicating the size of an envelope normalized by the maximum value $B_{MAX}$ of the amplitude and a drain voltage V normalized by the maximum value $V_{MAX}$ of the drain voltage.
FIG. 7 is an explanatory graph indicating a simulation result of the relationship between the output power and the efficiency of the high-frequency amplifier.
FIG. 8 is an explanatory graph indicating a simulation result of the frequency dependency of the efficiency at a back-off of 12 dB.

DESCRIPTION OF EMBODIMENT

To describe the present invention further in detail, embodiments of the present invention will be described below with reference to the accompanying drawings.

First Embodiment

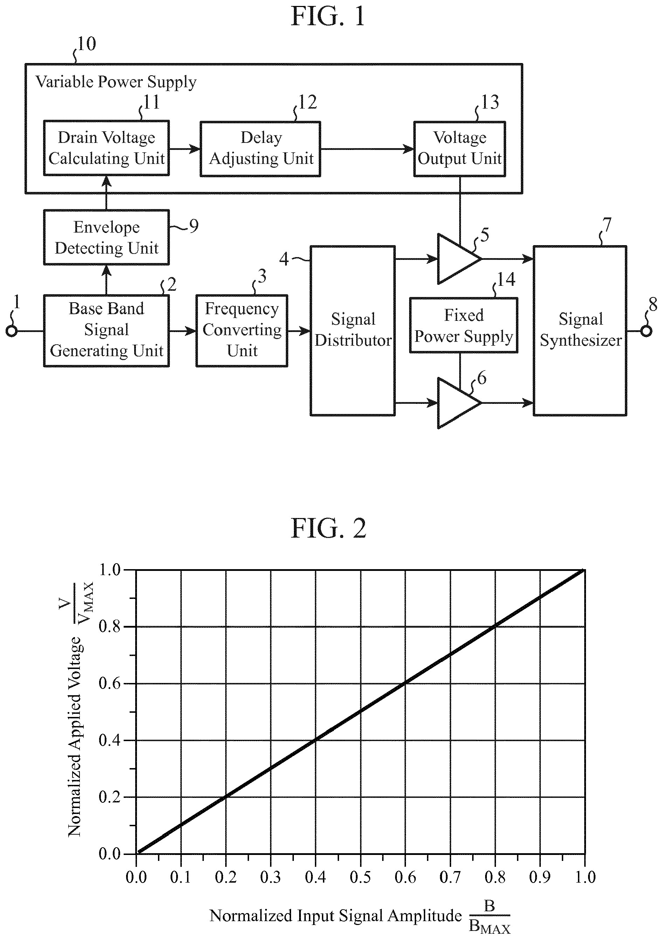

FIG. 1 is a configuration diagram illustrating a high-frequency amplifier according to a first embodiment of the invention.
In FIG. 1, an input terminal 1 receives a digital signal as a signal to be amplified.
A baseband signal generating unit 2 converts the digital signal input from the input terminal 1 into an analog signal, and outputs the converted analog signal to a frequency converting unit 3 and an envelope detecting unit 9 as a baseband signal.
The frequency converting unit 3 converts the baseband signal into a high frequency signal by converting the frequency of the baseband signal output from the baseband signal generating unit 2 into a carrier frequency and outputs the high frequency signal to a signal distributor 4.
The signal distributor 4 distributes the high frequency signal output from the frequency converting unit 3 to a carrier amplifier 5 and a peak amplifier 6.
The carrier amplifier 5 amplifies the high frequency signal distributed by the signal distributor 4 and outputs the amplified high frequency signal to a signal synthesizer 7.
As the carrier amplifier 5, for example, an amplification element operating in class AB is used.
In the first embodiment, an example in which the amplification element used in the carrier amplifier 5 is a source-grounded transistor will be described. In a case where a source-grounded transistor is used, an input terminal of the carrier amplifier 5 is a gate terminal, and an output terminal of the carrier amplifier 5 is a drain terminal.

The carrier amplifier 5 amplifies the high frequency signal regardless of whether the power of the one high frequency signals distributed by the signal distributor 4 is low or high.

The peak amplifier 6 amplifies the other high frequency signal distributed by the signal distributor 4 and outputs the amplified high frequency signal to the signal synthesizer 7.

As the peak amplifier 6, for example, an amplification element operating in class B or an amplification element operating in class C is used.

In the first embodiment, an example in which the amplification element used in the peak amplifier 6 is a source-grounded transistor will be described. In a case where a source-grounded transistor is used, an input terminal of the peak amplifier 6 is a gate terminal, and an output terminal of the peak amplifier 6 is a drain terminal.

A bias voltage to be applied to the gate terminal of the peak amplifier 6 is adjusted in such a manner that the peak amplifier 6 amplifies the other high frequency signal distributed by the signal distributor 4 when the power of the other signal distributed by the signal distributor 4 is higher than or equal to the operating power of the peak amplifier 6.

The operating power of the peak amplifier 6 is a power that causes saturation of the power of the output signal of the carrier amplifier 5 among the power of the one signal distributed by the signal distributor 4.

The signal synthesizer 7 combines the amplified high frequency signal output from the carrier amplifier 5 and the amplified high frequency signal output from the peak amplifier 6, and outputs the combined high frequency signal to an output terminal 8.

The output terminal 8 is a terminal for outputting the high frequency signal output from the signal synthesizer 7 to the outside.

The envelope detecting unit 9 detects the envelope of the baseband signal output from the baseband signal generating unit 2 and outputs the detected envelope to a variable power supply 10.

The variable power supply 10 includes a drain voltage calculating unit 11, a delay adjusting unit 12, and a voltage output unit 13, and the larger the envelope detected by the envelope detecting unit 9 is, the larger a voltage is applied to the drain terminal which is the output terminal of the carrier amplifier 5.

The drain voltage calculating unit 11 calculates a drain voltage to be applied to the drain terminal of the carrier amplifier 5 using the amplitude indicating the size of the envelope output from the envelope detecting unit 9 and the maximum value of the amplitude set in advance, and outputs voltage information indicating the calculated drain voltage to the delay adjusting unit 12.

The delay adjusting unit 12 temporarily holds the voltage information output from the drain voltage calculating unit 11 in such a manner that timing of input of the high frequency signals to the carrier amplifier 5 and the peak amplifier 6 matches the timing of application of the drain voltage to the drain terminal of the carrier amplifier 5 and then outputs the voltage information to the voltage output unit 13.

That is, the delay adjusting unit 12 outputs the voltage information to the voltage output unit 13 after holding the voltage information output from the drain voltage calculating unit 11 for a time length corresponding to signal delay time in the frequency converting unit 3 and the signal distributor 4.

The voltage output unit 13 applies the drain voltage, indicated by the voltage information output from the delay adjusting unit 12, to the drain terminal of the carrier amplifier 5.

A fixed power supply 14 applies a constant drain voltage to the drain terminal which is the output terminal of the peak amplifier 6.

Next, the operation will be described.

The baseband signal generating unit 2 converts the digital signal input from the input terminal 1 into an analog signal, and outputs the converted analog signal to the frequency converting unit 3 and the envelope detecting unit 9 as a baseband signal.

The frequency converting unit 3 converts the baseband signal into a high frequency signal by converting the frequency of the baseband signal output from the baseband signal generating unit 2 into a carrier frequency and outputs the high frequency signal to the signal distributor 4.

The signal distributor 4 distributes the high frequency signal output from the frequency converting unit 3 to the carrier amplifier 5 and the peak amplifier 6.

The carrier amplifier 5 amplifies the one high frequency signal distributed by the signal distributor 4 and outputs the amplified high frequency signal to the signal synthesizer 7.

The peak amplifier 6 is set to perform amplification when the power of an output signal of the carrier amplifier 5 is saturated due to a high power of the high frequency signal distributed by the signal distributor 4.

Therefore, the peak amplifier 6 does not perform amplification operation unless the power of an output signal of the carrier amplifier 5 is saturated. Alternatively, the peak amplifier 6 amplifies the other high frequency signal distributed by the signal distributor 4 when the power of the output signal of the carrier amplifier 5 is saturated, and outputs the amplified high frequency signal to the signal synthesizer 7.

The signal synthesizer 7 combines the amplified high frequency signal output from the carrier amplifier 5 and the amplified high frequency signal output from the peak amplifier 6, and outputs the combined high frequency signal to an output terminal 8.

In the first embodiment, the drain voltage to be applied to the drain terminal of the carrier amplifier 5 is adjusted depending on the power of the high frequency signal input to the carrier amplifier 5 in order to enable implementation of highly efficient operation without providing a phase shifter including a quarter wavelength line or the like.

A specific example is as follows.

The envelope detecting unit 9 detects the envelope of the baseband signal output from the baseband signal generating unit 2 and outputs the detected envelope to the variable power supply 10.

The drain voltage calculating unit 11 of the variable power supply 10 calculates a drain voltage V to be applied to the drain terminal, which is the output terminal of the carrier amplifier 5, using an amplitude B indicating the size of the envelope output from the envelope detecting unit 9 and the maximum value $B_{MAX}$ of the amplitude set in advance.

For example, as expressed by the following equations (1), the drain voltage calculating unit 11 calculates the drain voltage V to be applied to the drain terminal of the carrier amplifier 5 by dividing the amplitude B indicating the size of the envelope output from the envelope detecting unit 9 by the maximum value $B_{MAX}$ of the amplitude corresponding to a normalizing voltage of the amplitude. The drain voltage V is normalized by the maximum value $V_{MAX}$.

$$\frac{V}{V_{MAX}} = \frac{B}{B_{MAX}}$$

$$V = \frac{B}{B_{MAX}} \times V_{MAX} \qquad (1)$$

In equations (1), $V_{MAX}$ denotes the maximum value of the drain voltage V set in advance, and corresponds to a normalizing voltage of the drain voltage.

The drain voltage calculating unit 11 outputs voltage information indicating the drain voltage V to the delay adjusting unit 12.

The delay adjusting unit 12 temporarily holds the voltage information output from the drain voltage calculating unit 11 in such a manner that timing of input of the high frequency signals to the carrier amplifier 5 and the peak amplifier 6 matches the timing of application of the drain voltage to the drain terminal of the carrier amplifier 5 and then outputs the voltage information to the voltage output unit 13.

That is, the delay adjusting unit 12 outputs the voltage information to the voltage output unit 13 after holding the voltage information output from the drain voltage calculating unit 11 for a time length corresponding to signal delay time in the frequency converting unit 3 and the signal distributor 4.

The voltage output unit 13 applies the drain voltage V indicated by the voltage information output from the delay adjusting unit 12 to the drain terminal which is the output terminal of the carrier amplifier 5.

As a method of applying the drain voltage V by the voltage output unit 13, for example, pulse width modulation (PWM) can be used.

The PWM adjusts the drain voltage V to be applied to the drain terminal of the carrier amplifier 5 by switching ON time and OFF time of a pulse train.

In a case where the voltage output unit 13 uses the PWM, it is only required to set the ratio of the ON time $T_{ON}$ of each pulse in the pulse train to the pulse cycle $T_{ON+}$

$_{OFF}$ to that of V to $V_{MAX}$ as expressed by the following equation (2), for example.

$$T_{ON} : T_{ON+OFF} = V : V_{MAX} \qquad (2)$$

In this example, FIG. 2 is an explanatory graph indicating the relationship between the amplitude B indicating the size of the envelope normalized by the maximum value $B_{MAX}$ of the amplitude and the drain voltage V normalized by the maximum value $V_{MAX}$ of the drain voltage.

From FIG. 2, it can be understood that a drain voltage proportional to the envelope detected by the envelope detecting unit 9 is applied to the drain terminal of the carrier amplifier 5.

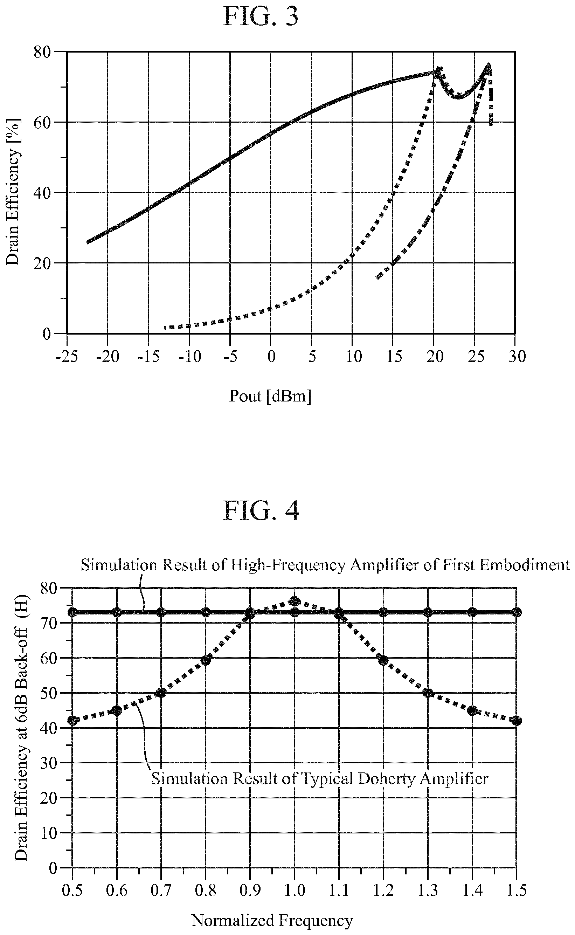

FIG. 3 is an explanatory graph indicating a simulation result of the relationship between the output power and the efficiency of the high-frequency amplifier.

In FIG. 3, the horizontal axis represents the output power Pout of the high-frequency amplifier, and the vertical axis represents the efficiency (drain efficiency).

A solid line indicates a simulation result of the high-frequency amplifier of FIG. 1 of the first embodiment, a dotted line indicates a simulation result of a typical Doherty amplifier, and a dashed dotted line indicates a simulation result of a single amplification element biased to Class B.

In this example, it is assumed in the typical Doherty amplifier that a fixed power supply is used instead of the variable power supply 10 of FIG. 1, that a quarter wavelength line is provided on the input side of the peak amplifier 6, and that a quarter wavelength line is provided on the output side of the carrier amplifier 5.

It is understood from FIG. 3 that the high-frequency amplifier of FIG. 1 of the first embodiment is more efficient regardless of the level of the output power Pout as compared with the typical Doherty amplifier and the single amplification element biased to Class B.

In particular, it is clear that the high-frequency amplifier of FIG. 1 has a higher efficiency for the output power Pout of less than or equal to 20 [dBm] as compared to those of the typical Doherty amplifier and the single amplification element biased to Class B.

FIG. 4 is an explanatory graph indicating a simulation result of the frequency dependency of the efficiency at a back-off of 6 dB.

The horizontal axis represents the normalized frequency, and the vertical axis represents the efficiency when the back-off is 6 dB.

A solid line indicates a simulation result of the high-frequency amplifier of FIG. 1 of the first embodiment, and a dotted line indicates a simulation result of a typical Doherty amplifier.

The typical Doherty amplifier has the highest efficiency at a normalized frequency of 1.0. The efficiency drops as the normalized frequency drops below 1.0, and the efficiency also drops as the normalized frequency rises above 1.0.

The high-frequency amplifier of FIG. 1 of the first embodiment constantly has a high efficiency of about 73 (H) even when the normalized frequency varies. Therefore, it can be understood that the high-frequency amplifier of FIG. 1 is not frequency-dependent.

As apparent from the above, according to the first embodiment, the envelope detecting unit 9 for detecting the envelope of a signal to be amplified is provided, and the variable power supply 10 applies, to the output terminal of the carrier amplifier 5, a voltage increased with increase in the envelope detected by the envelope detecting unit 9, therefore an effect is exerted that highly efficient operation can be implemented without including a phase shifter including a quarter wavelength line or the like.

Second Embodiment

In a second embodiment, an example will be explained in which the operating power of a peak amplifier 21 is lower than the power that causes saturation of the power of an output signal of a carrier amplifier 5 among the power of the one high frequency signal distributed by a signal distributor 4.

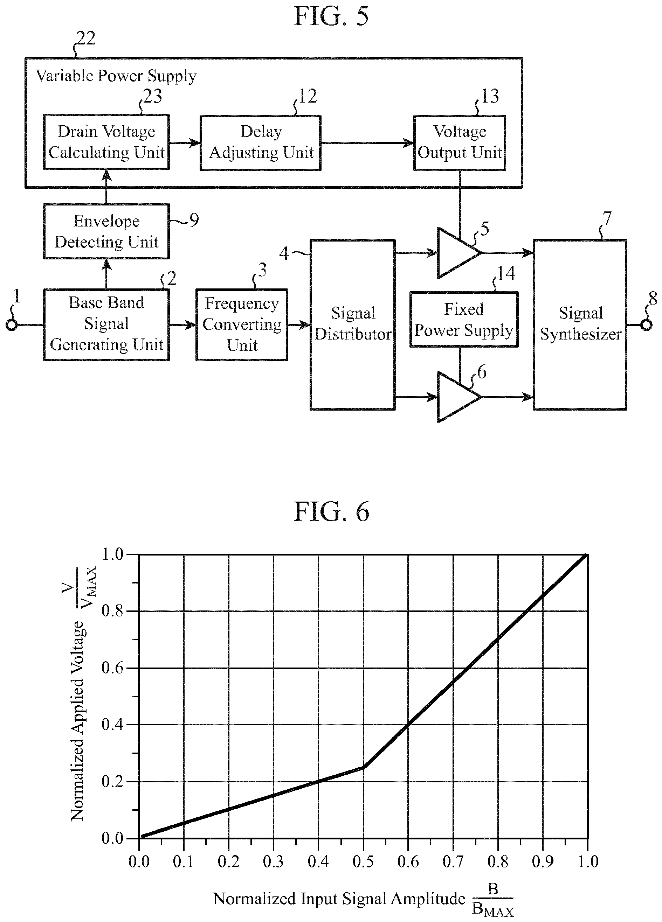

FIG. 5 is a configuration diagram illustrating a high-frequency amplifier according to a second embodiment of the invention. In FIG. 5, the same symbol as that in FIG. 1 represents the same or a corresponding part, and thus descriptions thereof are omitted.

A peak amplifier 21 amplifies the other high frequency signal distributed by a signal distributor 4 and outputs the amplified high frequency signal to a signal synthesizer 7.

As the peak amplifier 21, for example, an amplifier operating in class B or an amplifier operating in class C is used.

In the second embodiment, an example in which an amplification element used in the peak amplifier 21 is a source-grounded transistor will be described. In a case where a source-grounded transistor is used, an input terminal of the peak amplifier 21 is a gate terminal, and an output terminal of the peak amplifier 21 is a drain terminal.

A bias voltage to be applied to the input terminal of the peak amplifier 21 is adjusted in such a manner that the peak amplifier 21 amplifies the other high frequency signal distributed by the signal distributor 4 when the power of the other signal distributed by the signal distributor 4 is higher than or equal to the operating power of the peak amplifier 21.

The operating power of the peak amplifier 21 is lower than the power that causes saturation of the power of the output signal of a carrier amplifier 5 among the power of the one signal distributed by the signal distributor 4.

A variable power supply 22 includes a drain voltage calculating unit 23, a delay adjusting unit 12, and a voltage output unit 13, and the larger an envelope detected by an envelope detecting unit 9 is, the larger a drain voltage is applied to a drain terminal of the carrier amplifier 5.

The drain voltage calculating unit 23 calculates a drain voltage to be applied to the drain terminal of the carrier amplifier 5 using the amplitude indicating the size of the envelope output from the envelope detecting unit 9 and the maximum value of the amplitude set in advance, and outputs voltage information indicating the calculated drain voltage to the delay adjusting unit 12.

That is, the drain voltage calculating unit 23 compares the amplitude indicating the size of the envelope detected by the envelope detecting unit 9 with a threshold value, and if the amplitude is less than the threshold value, calculates a drain voltage a ratio of which to the amplitude is a first ratio.

If the amplitude is greater than or equal to the threshold value, the drain voltage calculating unit 23 calculates a drain voltage a ratio of which to the amplitude is a second ratio that is larger than the first ratio.

Next, the operation will be described.

The baseband signal generating unit 2 converts a digital signal input from an input terminal 1 into an analog signal like in the first embodiment, and outputs the converted analog signal to a frequency converting unit 3 and the envelope detecting unit 9 as a baseband signal.

The frequency converting unit 3 converts the baseband signal into a high frequency signal by converting the frequency of the baseband signal output from the baseband signal generating unit 2 into a carrier frequency and outputs the high frequency signal to the signal distributor 4 like in the first embodiment.

The signal distributor 4 distributes the high frequency signal output from the frequency converting unit 3 to the carrier amplifier 5 and the peak amplifier 21 like in the first embodiment.

The carrier amplifier 5 amplifies the one high frequency signal distributed by the signal distributor 4 and outputs the amplified high frequency signal to the signal synthesizer 7 like in the first embodiment.

The peak amplifier 21 amplifies the other high frequency signal distributed by the signal distributor 4 and outputs the amplified high frequency signal to the signal synthesizer 7.

The operating power of the peak amplifier 21 is set to be higher than the lowest power at which the carrier amplifier 5 performs amplification and to be lower than the power that causes saturation of the power of the output signal of the carrier amplifier 5 among the power of the one signal distributed by the signal distributor 4.

Therefore, the lowest power for the peak amplifier 21 to perform amplification is higher than the lowest power for the carrier amplifier 5 to perform amplification.

The signal synthesizer 7 combines the amplified high frequency signal output from the carrier amplifier 5 and the amplified high frequency signal output from the peak amplifier 21, and outputs the combined high frequency signal to the output terminal 8.

In the second embodiment, the drain voltage to be applied to the drain terminal of the carrier amplifier 5 is adjusted depending on the power of the high frequency signal input to the carrier amplifier 5 in order to enable implementation of highly efficient operation without providing a phase shifter including a quarter wavelength line or the like.

A specific example is as follows.

The envelope detecting unit 9 detects the envelope of a baseband signal output from the baseband signal generating unit 2 and outputs the detected envelope to the variable power supply 22 like in the first embodiment.

The drain voltage calculating unit 23 of the variable power supply 22 divides the amplitude B indicating the size of the envelope output from the envelope detecting unit 9 by the maximum value $B_{MAX}$ of the amplitude corresponding to a normalizing voltage of the amplitude, and compares the division result $B/B_{MAX}$ with a preset threshold value Th. The threshold value Th is set to, for example, a half of the preset maximum value $B_{MAX}$ of the amplitude.

If the division result $B/B_{MAX}$ is less than the threshold value Th, the drain voltage calculating unit 23 calculates the drain voltage V normalized by the maximum value $V_{MAX}$ a ratio of which to the amplitude B normalized by the maximum value $B_{MAX}$ is a first ratio $R_1$ as expressed by the following equations (3).

If the division result $B/B_{MAX}$ is greater than or equal to the threshold value Th, the drain voltage calculating unit 23 calculates the drain voltage V normalized by the maximum value $V_{MAX}$ a ratio of which to the amplitude B normalized by the maximum value $B_{MAX}$ is a second ratio $R_2$, which is larger than the first ratio $R_1$ as expressed by the following equations (4).

For example, $R_1 = 0.5$ and $R_2 = 1.5$ are conceivable.

(1) In a case where $B/B_{MAX} < Th$ holds.

$$\frac{V}{V_{MAX}} = \frac{B}{B_{MAX}} \times R_1$$

$$V = \frac{B}{B_{MAX}} \times V_{MAX} \times R_1 \qquad (3)$$

(2) In a case where $B/B_{MAX} \geq Th$ holds.

$$\frac{V}{V_{MAX}} = \left(\frac{B}{B_{MAX}} - Th\right) \times R_2 + \text{Th} \times R_1$$

$$V = \left(\frac{B}{B_{MAX}} - Th\right) \times R_2 \times V_{MAX} + \text{Th} \times R_1 \times V_{MAX} \qquad (4)$$

In the equations (3) and (4), $V_{MAX}$ denotes the maximum value of the drain voltage V set in advance, and corresponds to the normalizing voltage of the drain voltage V.

The drain voltage calculating unit 23 outputs voltage information indicating the drain voltage V to the delay adjusting unit 12.

Here, the example in which the division result $B/B_{MAX}$ is compared with the threshold value Th has been described since the drain voltage calculating unit 23 normalizes each of the amplitude and the drain voltage; however, the present invention is not limited to normalizing each of the amplitude and the drain voltage.

In a case where it is not that each of the amplitude and the drain voltage is normalized, the drain voltage calculating unit 23 compares the amplitude B indicating the size of the envelope with a preset threshold value. In this case, the drain voltage V calculated by the drain voltage calculating unit 23 is not normalized by the maximum value $V_{MAX}$.

The delay adjusting unit 12 temporarily holds the voltage information output from the drain voltage calculating unit 23 in such a manner that timing of input of the high frequency signals to the carrier amplifier 5 and the peak amplifier 6 matches the timing of application of the drain voltage to the output terminal of the carrier amplifier 5, and then outputs the voltage information to the voltage output unit 13.

That is, the delay adjusting unit 12 outputs the voltage information to the voltage output unit 13 after holding the voltage information output from the drain voltage calculating unit 23 for a time length corresponding to signal delay time in the frequency converting unit 3 and the signal distributor 4.

Like in the first embodiment, the voltage output unit 13 applies the drain voltage V indicated by the voltage information output from the delay adjusting unit 12 to the drain terminal which is the output terminal of the carrier amplifier 5.

In a case where the voltage output unit 13 uses the PWM, it is only required to set the ratio of the ON time $T_{ON}$ of each pulse in a pulse train to the pulse cycle $T_{ON + OFF}$ to that of V to $V_{MAX}$ as expressed by the following equation (5), for example.

$$T_{ON} : T_{ON + OFF} = V : V_{MAX} \qquad (5)$$

In this example, FIG. 6 is an explanatory graph indicating the relationship between the amplitude B indicating the size of the envelope normalized by the maximum value $B_{MAX}$ of the amplitude and the drain voltage V normalized by the maximum value $V_{MAX}$ of the drain voltage.

From FIG. 6, it can be understood that a drain voltage proportional to the envelope detected by the envelope detecting unit 9 is applied to the drain terminal of the carrier amplifier 5.

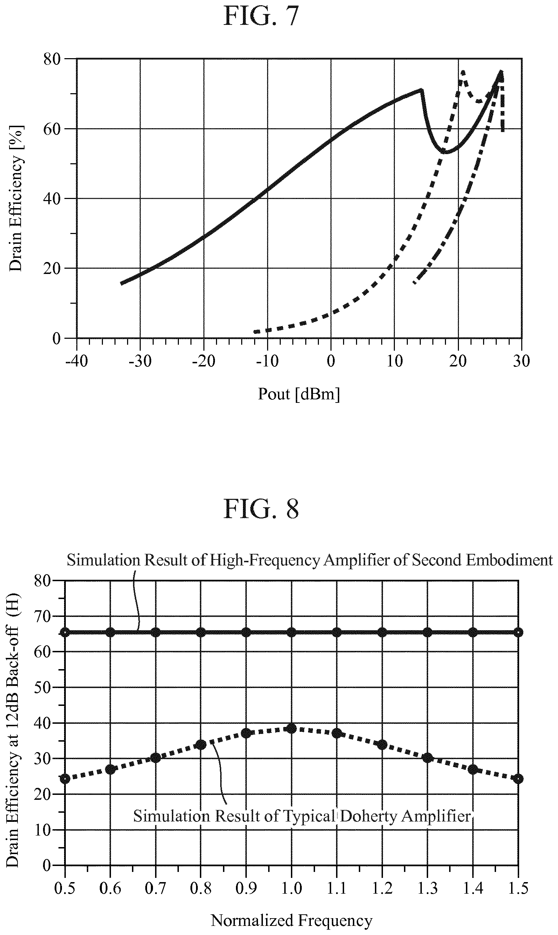

FIG. 7 is an explanatory graph indicating a simulation result of the relationship between the output power and the efficiency of the high-frequency amplifier.

In FIG. 7, the horizontal axis represents the output power Pout of the high-frequency amplifier, and the vertical axis represents the efficiency (drain efficiency).

A solid line indicates a simulation result of the high-frequency amplifier of FIG. 5 of the second embodiment, a dotted line indicates a simulation result of a typical Doherty amplifier, and a dashed dotted line indicates a simulation result of a single amplification element biased to Class B.

It is understood from FIG. 7 that the high-frequency amplifier of FIG. 5 of the second embodiment is more efficient as compared with the typical Doherty amplifier and the single amplification element biased to Class B for the output power Pout of less than or equal to approximately 17 [dBm].

FIG. 8 is an explanatory graph indicating a simulation result of the frequency dependency of the efficiency at a back-off of 12 dB.

The horizontal axis represents the normalized frequency, and the vertical axis represents the efficiency when the back-off is 12 dB.

A solid line indicates a simulation result of the high-frequency amplifier of FIG. 5 of the second embodiment, and a dotted line indicates a simulation result of a typical Doherty amplifier.

The typical Doherty amplifier has the highest efficiency at a normalized frequency of 1.0. The efficiency drops as the normalized frequency drops below 1.0, and the efficiency also drops as the normalized frequency rises above 1.0.

The high-frequency amplifier of FIG. 5 of the second embodiment constantly has a high efficiency of about 65 (H) even when the normalized frequency varies. Therefore, it can be understood that the high-frequency amplifier of FIG. 5 is not frequency-dependent.

As apparent from the above, according to the second embodiment, the envelope detecting unit 9 for detecting the envelope of a signal to be amplified is provided, and the variable power supply 22 applies, to the output terminal of the carrier amplifier 5, a voltage increased with increase in the envelope detected by the envelope detecting unit 9, therefore an effect is exerted that highly efficient operation can be implemented without providing a phase shifter including a quarter wavelength line or the like.

Note that the present invention may include a flexible combination of the respective embodiments, a modification of any component of each embodiment, or an omission of any component in each embodiment within the scope of the present invention.

INDUSTRIAL APPLICABILITY

The invention is suitable for a high-frequency amplifier including a carrier amplifier and a peak amplifier.

REFERENCE SIGNS LIST

1: input terminal,

2: baseband signal generating unit,

3: frequency converting unit,

4: signal distributor,

5: carrier amplifier,

6: peak amplifier,

7: signal synthesizer,

8: output terminal,

9: envelope detecting unit,

10: variable power supply,

11: drain voltage calculating unit,

12: delay adjusting unit,

13: voltage output unit,

14: fixed power supply,

21: peak amplifier,

22: variable power supply, and

23: drain voltage calculating unit

**Claims**

1. A high-frequency amplifier comprising:

a signal distributor for distributing a signal to be amplified;

a carrier amplifier for amplifying one signal distributed by the signal distributor;

a peak amplifier for amplifying the other signal distributed by the signal distributor;

a signal synthesizer for combining the signal amplified by the carrier amplifier and the signal amplified by the peak amplifier;

an envelope detecting unit for detecting an envelope of the signal to be amplified; and

a variable power supply for applying, to an output terminal of the carrier amplifier, a voltage increased with increase in the envelope detected by the envelope detecting unit.

2. The high-frequency amplifier according to claim 1, wherein
a bias voltage to be applied to an input terminal of the peak amplifier is adjusted in such a manner that the peak amplifier amplifies the other signal distributed by the signal distributor when a power of the other signal distributed by the signal distributor is higher than or equal to an operating power of the peak amplifier, and
the operating power of the peak amplifier is a power that causes saturation of a power of the output signal of the carrier amplifier among a power of the one signal distributed by the signal distributor.

3. The high-frequency amplifier according to claim 1, wherein the variable power supply applies, to the output terminal of the carrier amplifier, a voltage proportional to the envelope detected by the envelope detecting unit.

4. The high-frequency amplifier according to claim 1,
wherein a bias voltage to be applied to an input terminal of the peak amplifier is adjusted in such a manner that the peak amplifier amplifies the other signal distributed by the signal distributor when a power of the other signal distributed by the signal distributor is higher than or equal to an operating power of the peak amplifier, and
the operating power of the peak amplifier is lower than a power that causes saturation of a power of the output signal of the carrier amplifier among a power of the one signal distributed by the signal distributor.

5. The high-frequency amplifier according to claim 1,
wherein the variable power supply applies, to the output terminal of the carrier amplifier, a voltage indicating a first ratio that is a ratio to the envelope when the envelope detected by the envelope detecting unit is less than a threshold value and applies, to the output terminal of the carrier amplifier, a voltage indicating a second ratio larger in ratio to the envelope than the first ratio when the envelope is higher than or equal to the threshold value.

# FIG. 1

# FIG. 2

## FIG. 3

## FIG. 4

Simulation Result of High-Frequency Amplifier of First Embodiment

Simulation Result of Typical Doherty Amplifier

# FIG. 5

Variable Power Supply 22

Drain Voltage Calculating Unit 23 → Delay Adjusting Unit 12 → Voltage Output Unit 13

Envelope Detecting Unit 9

Base Band Signal Generating Unit 2 → Frequency Converting Unit 3 → Signal Distributor 4

Fixed Power Supply 14

Signal Synthesizer 7

# FIG. 6

Normalized Applied Voltage $\frac{V}{V_{MAX}}$ vs Normalized Input Signal Amplitude $\frac{B}{B_{MAX}}$

## FIG. 7

## FIG. 8

## INTERNATIONAL SEARCH REPORT

| | International application No. |
|---|---|
| | PCT/JP2017/023200 |

**A. CLASSIFICATION OF SUBJECT MATTER**
*H03F1/07(2006.01)i*

According to International Patent Classification (IPC) or to both national classification and IPC

**B. FIELDS SEARCHED**

Minimum documentation searched (classification system followed by classification symbols)
H03F1/07

Documentation searched other than minimum documentation to the extent that such documents are included in the fields searched
Jitsuyo Shinan Koho            1922–1996   Jitsuyo Shinan Toroku Koho   1996–2017
Kokai Jitsuyo Shinan Koho   1971–2017   Toroku Jitsuyo Shinan Koho   1994–2017

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2010/084544 A1  (NEC Corp.),<br>29 July 2010 (29.07.2010),<br>paragraphs [0014] to [0036]; fig. 1 to 5<br>& EP 2383884 A1<br>paragraphs [0014] to [0036]; fig. 1 to 5<br>& US 2011/0285460 A1    & CN 102282761 A | 1–5 |
| A | JP 2015-220680 A  (Mitsubishi Electric Corp.),<br>07 December 2015 (07.12.2015),<br>paragraphs [0040] to [0042]; fig. 12<br>(Family: none) | 1–5 |

| ☒ | Further documents are listed in the continuation of Box C. | ☐ | See patent family annex. |

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 30 August 2017 (30.08.17) | 12 September 2017 (12.09.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

| International application No. |
|---|
| PCT/JP2017/023200 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2017-511079 A  (Qualcomm Inc.),<br>13 April 2017 (13.04.2017),<br>paragraphs [0009] to [0014]; fig. 1<br>& US 2015/0295541 A1<br>paragraphs [0014] to [0019]; fig. 1<br>& WO 2015/157361 A1     & CN 106134071 A | 1-5 |

Form PCT/ISA/210 (continuation of second sheet) (January 2015)

**EP 3 624 335 A1**

**Patent documents cited in the description**

- WO 2010084544 A